# EUROPEAN PATENT APPLICATION

(11) **EP 4 310 591 A1**
(43) Date of publication of application: **24.01.2024**
(21) Application number: 22771437.5
(22) Date of filing: 15.03.2022
(51) Int. Cl.: G03F 1/26, G03F 1/54

(54) **PHASE SHIFT MASK BLANK, PHASE SHIFT MASK, AND METHOD FOR MANUFACTURING PHASE SHIFT MASK**

(30) Priority: 19.03.2021 JP 2021045517
(71) Applicant: Toppan Photomask Co., Ltd., Tokyo 108-0023 (JP)
(72) Inventor: KUROKI, Kyoko, Tokyo 110-0016 (JP); MATSUI, Kazuaki, Tokyo 110-0016 (JP); KOJIMA, Yosuke, Tokyo 110-0016 (JP)
(74) Representative: Hoffmann Eitle
(86) International application number: PCT/JP2022/011647
(87) International publication number: WO 2022/196692

(57) **Abstract**

Provided are a phase shift mask blank that suppresses the formation of haze on a phase shift film surface and reduces film peeling during cleaning or a level difference in a cross-section of a modified portion during modification etching to improve transfer performance, a phase shift mask, and a method for manufacturing a phase shift mask. A phase shift mask blank (10) according to an embodiment of the present invention is a phase shift mask blank used for producing a phase shift mask to which exposure light having a wavelength of 200 nm or less is applied, the phase shift mask blank (10) including a transparent substrate (11) and a phase shift film (12), in which the phase shift film (12) includes a phase difference and transmittance adjustment layer (13), a protective layer against gas permeation (15), and a compositionally graded layer (14), and in the compositionally graded layer (14), a content of a component configuring the phase difference and transmittance adjustment layer (13) decreases from the substrate side (11) toward the protective layer against gas permeation (15) side, and a content of a component configuring the protective layer against gas permeation (15) increases from the substrate (11) side toward the protective layer against gas permeation (15) side.

## Description

### Technical Field

The present invention relates to a phase shift mask blank, a phase shift mask, and a method for manufacturing a phase shift mask that are used for manufacturing semiconductor devices and the like.

### Background Art

Recently, in semiconductor processing, nanofabrication of a circuit pattern has been required particularly along with high integration of a large scale integrated circuit, and a demand for a nanofabrication technique of interconnection patterns or contact hole patterns configuring the circuit has increased. Therefore, as an exposure light source used for manufacturing semiconductor devices and the like, shifting to a shorter wavelength from a KrF excimer laser (wavelength: 248 nm) to an ArF excimer laser (wavelength: 193 nm) has progressed.

In addition, as a mask for improving wafer transfer characteristics, for example, a phase shift mask is used. In the phase shift mask, in order that a phase difference between ArF excimer laser light that transmits through a transparent substrate and ArF excimer laser light that transmits through both of a transparent substrate and a phase shift film (hereinafter, simply referred to as "phase difference") is 180 degrees and to adjust a ratio of the amount of ArF excimer laser light that transmits through both of a transparent substrate and a phase shift film to the amount of ArF excimer laser light that transmits through a transparent substrate (hereinafter, simply referred to as "transmittance") is 6%, both of the phase difference and the transmittance can be adjusted.

For example, a method is known, in which when the phase shift mask where the phase difference is 180 degrees is manufactured, after setting the film thickness of the phase shift film such that the phase difference is about 177 degrees, a transparent substrate is processed into about 3 nm while dry etching the phase shift film with fluorine-based gas, and finally the phase difference is adjusted to about 180 degrees.

In a phase shift mask to which exposure light having a wavelength of 200 nm or less is applied, foreign matter called "haze" is gradually formed, grown, and visualized by exposure, and the mask cannot be used. In particular, when the phase shift film is a film including silicon, transition metal, and a light element such as oxygen or nitrogen, foreign matter may be formed on the phase shift film surface.

Techniques for suppressing the haze are described in, for example, PTLs 1 and 2.

However, in the techniques described in PTLs 1 and 2, the effect of suppressing the above-described haze may be insufficient.

In addition, in a method for manufacturing a phase shift mask blank to which exposure light having a wavelength of 200 nm or less is applied, typically, a phase shift film is formed on a substrate by sputtering. Stress is generated in the formed phase shift film, this film stress is partially released by etching during the manufacturing of a phase shift mask, and the positional accuracy of the phase shift mask pattern may deteriorate.

A technique for relaxing the stress of the phase shift film is described in, for example, PTL 3.

However, in the technology described in PTL 3, particularly when the phase shift film has a multi-layer structure including films having different compositions, the degree of stress relaxation varies depending on the films configuring the phase shift film. Therefore, the adhesion force of a film interface may decrease, and film peeling may occur during the cleaning of the phase shift mask. That is, as one method of suppressing the formation of haze in the phase shift mask, a method of depositing the phase shift film, that is, a method of forming the phase shift film having the multi-layer structure is used. In this case, the interlayer adhesion force in the phase shift film may decrease, and film peeling may occur during the cleaning of the phase shift mask. As a result, the transfer performance may also deteriorate.

Further, when the phase shift film has a multi-layer structure formed of films having different compositions, a modification etching rate during mask pattern modification varies depending on the films. Therefore, there is a level difference in a shape of a cross-section of a modified portion, and thus the transfer performance may deteriorate.

### Citation List

### Patent Literatures

PTL 1: JP 2018-173621 A
PTL 2: JP 4579728 B
PTL 3: JP 4687929 B

### Summary of Invention

### Technical Problem

The present invention has been made under the above-described circumstances, and an object thereof is to provide a phase shift mask blank that can sufficiently suppress the formation of haze on a phase shift film surface, a phase shift mask having reduced haze defects and having excellent pattern cleaning resistance or transfer performance, and a method for manufacturing the phase shift mask. That is, an object of the present invention is to provide a phase shift mask blank that suppresses the formation of haze on a phase shift film surface and reduces film peeling during cleaning or a level difference in a cross-section of a modified portion during modification etching to improve transfer performance, a phase shift mask, and a method for manufacturing a phase shift mask.

### Solution to Problem

The present invention has been made in order to achieve the above-described object, and according to one aspect of the present invention, there is provided a phase shift mask blank used for producing a phase shift mask to which exposure light having a wavelength of 200 nm or less is applied, the phase shift mask blank including: a transparent substrate; and a phase shift film formed on the transparent substrate, in which the phase shift film includes a phase difference and transmittance adjustment layer that is capable of adjusting a predetermined amount of each of a phase and a transmittance with respect to exposure light to be transmitted, a protective layer against gas permeation formed on the phase difference and transmittance adjustment layer and that prevent gas permeation to the phase difference and transmittance adjustment layer, and a compositionally graded layer positioned between the phase difference and transmittance adjustment layer and the protective layer against gas permeation and is a region where a ratio between a content of a component configuring the phase difference and transmittance adjustment layer and a content of a component configuring the protective layer against gas permeation continuously changes in a film thickness direction, and in the compositionally graded layer, the content of the component configuring the phase difference and transmittance adjustment layer decreases from the substrate side toward the protective layer against gas permeation side, and the content of the component configuring the protective layer against gas permeation increases from the substrate side toward the protective layer against gas permeation side.

In addition, according to another aspect of the present invention, there is provided a phase shift mask having a circuit pattern to which exposure light having a wavelength of 200 nm or less is applied, the phase shift mask including: a transparent substrate; and a phase shift film formed on the transparent substrate, in which the phase shift film includes a phase difference and transmittance adjustment layer that is capable of adjusting a predetermined amount of each of a phase and a transmittance with respect to exposure light to be transmitted, a protective layer against gas permeation formed on the phase difference and transmittance adjustment layer and that prevent gas permeation to the phase difference and transmittance adjustment layer, and a compositionally graded layer positioned between the phase difference and transmittance adjustment layer and the protective layer against gas permeation and is a region where a ratio between a content of a component configuring the phase difference and transmittance adjustment layer and a content of a component configuring the protective layer against gas permeation continuously changes in a film thickness direction, and in the compositionally graded layer, the content of the component configuring the phase difference and transmittance adjustment layer decreases from the substrate side toward the protective layer against gas permeation side, and the content of the component configuring the protective layer against gas permeation increases from the substrate side toward the protective layer against gas permeation side.

In addition, according to still another aspect of the present invention, there is provided a method for manufacturing a phase shift mask using the above-described phase shift mask blank, the method including: a step of forming a light shielding film on the phase shift film; a step of forming a resist pattern on the light shielding film; a step of forming a pattern on the light shielding film by oxygen-containing chlorine-based etching (Cl/O-based) after forming the resist pattern; a step of forming a pattern on the phase shift film by fluorine-based etching (F-based) after forming the pattern on the light shielding film; a step of removing the resist pattern after forming the pattern on the phase shift film; and a step of removing the light shielding film by oxygen-containing chlorine-based etching (Cl/O-based) from the phase shift film after removing the resist pattern.

### Advantageous Effects of Invention

By using the phase shift mask blank according to the aspect of the present invention, the formation of haze on the phase shift mask can be sufficiently suppressed, and the cleaning resistance or the transfer performance of the pattern can be improved. That is, with the phase shift mask blank and the phase shift mask according to the aspects of the present invention, the formation of haze on the phase shift film surface can be suppressed, and excellent cleaning resistance and excellent transfer performance can be given to the phase shift mask.

### Brief Description of Drawings

FIG. 1 is a schematic cross-sectional view illustrating a configuration of a phase shift mask blank according to an embodiment of the present invention;
FIGS. 2A to 2D are diagrams illustrating aspects of compositional grading of a compositionally graded layer in the phase shift mask blank according to the embodiment of the present invention;
FIG. 3 is a schematic cross-sectional view illustrating a configuration of a phase shift mask according to an embodiment of the present invention;
FIGS. 4A to 4F are schematic cross-sectional views illustrating steps of manufacturing a phase shift mask using the phase shift mask blank according to the embodiment of the present invention; and
FIGS. 5A and 5B are diagrams schematically illustrating one side of a cross-section of a phase shift film pattern after modifying the phase shift mask according to the embodiment of the present invention.

### Description of Embodiments

The present inventors thought that, unless conditions of three elements including a constituent material of a phase adjustment film (a phase difference and transmittance adjustment layer described below) configuring a phase shift mask blank or a phase shift mask, moisture or an oxidizing gas such as oxygen, and exposure energy are satisfied, the formation of haze in the mask blank or the mask can be reduced, thereby completing a phase shift mask blank or a phase shift mask having the following configuration. That is, the phase shift mask blank, the phase shift mask, and method for manufacturing the phase shift mask according to the present embodiment are based on a technical idea that, by providing a gas protective layer (a so-called gas barrier layer) on a phase adjustment film, the constituent material of the phase adjustment film is prevented from coming into contact with the oxidizing gas such that the formation of haze is reduced.

Furthermore, the present inventors established a technique in which, when a gas protective layer is provided on a phase adjustment film, compositions of the phase adjustment film and the gas protective layer are gradually mixed with each other and a clear interface of the layers is removed to prevent interfacial peeling caused by a difference in internal stress between the films and the occurrence of a level difference of a pattern cross-section caused by a difference in modification etching rate is reduced to prevent deterioration of transfer performance.

Embodiments of the present invention will be described with reference to the following drawings.

A schematic cross-sectional view does not exactly reflect an actual dimensional ratio or the number of patterns, and the digging amount of a transparent substrate or the damage amount of a film is not illustrated.

Examples of a preferable embodiment of the phase shift mask blank according to the present invention include the following aspect.

### (Overall Configuration of Phase Shift Mask Blank)

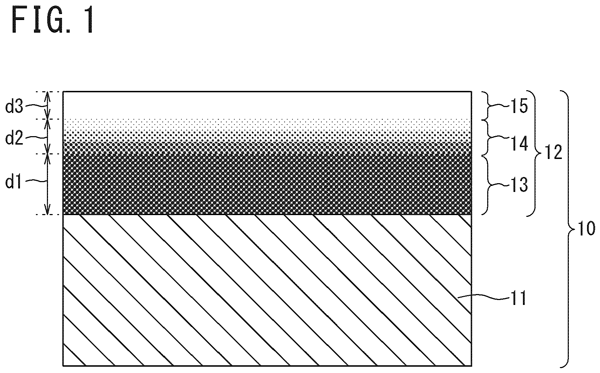

FIG. 1 is a schematic cross-sectional view illustrating a configuration of a phase shift mask blank according to an embodiment of the present invention. A phase shift mask blank 10 illustrated in FIG. 1 is a phase shift mask blank used for producing a phase shift mask to which exposure light having a wavelength of 200 nm or less is applied, the phase shift mask blank including: a substrate (hereinafter, also simply referred to as "substrate") 11 that is transparent with respect to the exposure wavelength; and a phase shift film 12 formed on the substrate 11. In addition, the phase shift film 12 includes at least a phase difference and transmittance adjustment layer (hereinafter, also simply referred to as "phase layer") 13 that is capable of adjusting a predetermined amount of each of a phase and a transmittance with respect to exposure light to be transmitted, a protective layer against gas permeation (hereinafter, simply referred to as "protective layer) 15 formed on the phase difference and transmittance adjustment layer 13 and that prevent gas permeation to the phase difference and transmittance adjustment layer 13, and a compositionally graded layer (hereinafter, simply referred to as "graded layer") 14 positioned between the phase layer 13 and the protective layer 15 and is a section (region) where a ratio between a composition of the phase layer 13 (a content of a component configuring the phase layer 13) and a composition of the protective layer 15 (a content of a component configuring the protective layer 15) continuously changes in a film depth direction (film thickness direction). In the phase shift film 12, the phase layer 13 is positioned on the substrate 11 side. In addition, when a film thickness of the phase layer 13 is set to d1, a film thickness of the graded layer 14 is set to d2, and a film thickness of the protective layer 15 is set to d3, it is preferable that a total film thickness of d1 and d2 is more than d3 and d3 is 15 nm or less.

Hereinafter, each of the layers configuring the phase shift mask blank 10 according to an embodiment of the present invention will be described in detail.

### (Substrate)

The substrate 11 is not particularly limited. As the substrate 11, for example, quartz glass, CaF₂, or aluminosilicate glass is generally used.

### (Phase Shift Film)

The phase shift film 12 includes the phase layer 13, the graded layer 14, and the protective layer 15 in this order, and is formed on the substrate 11 with or without another film interposed.

The phase shift film 12 is, for example, a film that has resistance to oxygen-containing chlorine-based etching (Cl/O-based) and is etchable by fluorine-based etching (F-based).

A value of the transmittance of the phase shift film 12 is in a range of, for example, 3% or more and 80% or less with respect to the transmittance of the substrate 11, and an optimum transmittance can be appropriately selected for a desired wafer pattern. In addition, the value of the phase difference of the phase shift film 12 is in a range of, for example, 160 degrees or more and 220 degrees or less and is more preferably in a range of 175 degrees or more and 190 degrees or less. That is, in the phase shift film 12, the transmittance with respect to the exposure light may be in a range of 3% or more and 80% or less, and the phase difference may be in a range of 160 degrees or more and 220 degrees or less. When the transmittance is less than 3% with respect to the exposure light of the phase shift film 12, there may be a case where favorable exposure performance cannot be obtained. In addition, when the phase difference is in a range of 160 degrees or more and 220 degrees or less, required exposure performance can be easily maintained.

### <Phase Layer>

The phase layer 13 is a layer formed on the substrate 11 with or without another film interposed and is capable of adjusting a predetermined amount of each of a phase and a transmittance with respect to exposure light to be transmitted. Here, "adjusting the phase" refers to, for example, inverting the phase. In addition, "transmittance" refers to the transmittance with respect to the exposure light.

The phase layer 13 is, for example, is a single-layer film that contains silicon and contains at least one selected from transition metal, nitrogen, oxygen, and carbon, a multi-layer film or a graded film thereof, and a layer where the transmittance and the phase difference with respect to the exposure wavelength are adjusted by appropriately selecting a composition and a film thickness. Here, "the graded film" refers to a film where a composition ratio between components configuring the phase layer 13 changes at a given ratio, not a film where the composition ratio is uniform over the entire phase layer 12.

In an element ratio of the entire phase layer 13, the content of silicon is preferably in a range of 20 at% or more and 60 at% or less, the content of transition metal is preferably in a range of 0 at% or more and 20 at% or less, the content of nitrogen is preferably in a range of 30 at% or more and 80 at% or less, the content of oxygen is preferably in a range of 0 at% or more and 30 at% or less, and the content of carbon is preferably in a range of 0 at% or more and 10 at% or less. As a more preferable range of the content of each of the elements in the phase layer 13, in the element ratio of the entire phase layer 13, the content of silicon is preferably in a range of 30 at% or more and 50 at% or less, the content of transition metal is preferably in a range of 0 at% or more and 10 at% or less, the content of nitrogen is preferably in a range of 40 at% or more and 70 at% or less, the content of oxygen is preferably in a range of 0 at% or more and 20 at% or less, and the content of carbon is preferably in a range of 0 at% or more and 5 at% or less. When the content of each of the elements in the phase layer 13 is in the above-described numerical range, not only the transmittance but also the phase difference of the phase layer 13 can be easily controlled.

In addition, the phase layer 13 may contain at least one of an oxide, a carbide, and a nitride of metal silicide. In this case, the metal configuring the metal silicide may be transition metal described below.

The transition metal in the phase layer 13 is preferably at least one selected from molybdenum, titanium, vanadium, cobalt, nickel, zirconium, niobium, and hafnium and is more preferably molybdenum. When the transition metal in the phase layer 13 is at least one selected from molybdenum, titanium, vanadium, cobalt, nickel, zirconium, niobium, and hafnium, the processing of the phase layer 13 is easy, and when the transition metal in the phase layer 13 is molybdenum, the processability during the etching of the phase layer 13 is further improved.

When the film thickness of the phase layer 13 is set to d1, the film thickness of the graded layer 14 is set to d2, and the film thickness of the protective layer 15 is set to d3, the total film thickness of the film thickness d1 of the phase layer 13 and the film thickness d2 of the graded layer 14 may be more than the film thickness d3 of the protective layer 15 and the film thickness d3 of the protective layer 15 may be 15 nm or less. In addition, when the film thickness d3 of the protective layer 15 is more than 15 nm, there may be an influence on optical characteristics or modification characteristics.

In the present embodiment, "the phase layer 13" is a layer that includes only the component (compound) configuring the phase layer 13 and does not include the component (compound) configuring the protective layer 15. In addition, "the protective layer 15" is a layer that includes only the component (compound) configuring the protective layer 15 and does not include the component (compound) configuring the phase layer 13. In addition, "the graded layer 14" is a layer that includes both of the component (compound) configuring the phase layer 13 and the component (compound) configuring the protective layer 15. That is, "the film thickness d1 of the phase layer 13" refers to the thickness (film thickness) of a region that includes only the component configuring the phase layer 13. In addition, "the film thickness d3 of the protective layer 15" refers to the thickness (film thickness) of a region that includes only the component configuring the protective layer 15. In addition, "the film thickness d2 of the graded layer 14" refers to the thickness (film thickness) of a region that includes both of the component configuring the phase layer 13 and the component configuring the protective layer 15.

In addition, the sum of the film thickness d1 of the phase layer 13 and the film thickness d2 of the graded layer 14 may be more than 15 nm. When the sum of the film thickness d1 of the phase layer 13 and the film thickness d2 of the graded layer 14 is more than 15 nm, each of the phase and the transmittance is easily adjusted.

In addition, the total film thickness of the film thickness d1 of the phase layer 13, the film thickness d2 of the graded layer 14, and the film thickness d3 of the protective layer 15 is preferably 50 nm or more and more preferably 70 nm or more. When the total film thickness of the film thickness d1 of the phase layer 13, the film thickness d2 of the graded layer 14, and the film thickness d3 of the protective layer 15 is in the above-described numerical range, the function of the phase shift film 12 is likely to be set to a desired value. The film thickness d1 of the phase layer 13 may be 0 nm when the transmittance and the phase difference with respect to the exposure wavelength can be sufficiently adjusted by the graded layer 14.

### <Protective Layer>

The protective layer 15 is a layer formed on the graded layer 14 with or without another film interposed and that prevents and suppresses gas permeation (in particular, permeation of moisture or an oxidizing gas such as oxygen) to the graded layer 14 and the phase layer 13, that is, a gas barrier layer. In the present embodiment, the permeation of the gas that is considered to be one element for the formation of haze to the graded layer 14 and the phase layer 13 can be prevented and suppressed. Therefore, even when the mask is used for a long period of time (for example, when a dosage on the mask exceeds 100 kJ/cm²), the formation of haze on the phase shift mask surface can be prevented and suppressed.

The gas (atmosphere gas) that prevents and suppresses the permeation in the protective layer 15 is oxidizing gas, specifically oxygen-containing molecules, and more specifically water molecules.

In addition, the protective layer 15 is preferably a layer that has resistance with respect to oxygen-containing chlorine-based (Cl/O-based) gas etching, is etchable with fluorine-based gas (F-based), and can be modified by an electron beam (EB) modification method.

The protective layer 15 is preferably a single-layer film that includes one or more compounds selected from tantalum metal, a tantalum compound, tungsten metal, a tungsten compound, tellurium metal, a tellurium compound, silicon metal, and a silicon compound, a mixed film of the compounds, or a multi-layer film of the compounds. However, the protective layer 15 is not particularly limited in composition as long as the protective layer 15 is a layer having a barrier function. The tantalum metal, the tungsten metal, the tellurium metal, and silicon metal refer to a simple substance of each of the metals.

The protective layer 15 including the tantalum compound is a single-layer film that contains tantalum and one or more elements selected from oxygen, nitrogen, and carbon or is a multi-layer film or a graded film thereof.

In the protective layer 15 including the tantalum compound, in an element ratio of the entire protective layer 15, the content of tantalum is preferably in a range of 10 at% or more and 90 at% or less, the content of oxygen is preferably in a range of 0 at% or more and 90 at% or less, the content of nitrogen is preferably in a range of 0 at% or more and 70 at% or less, and the content of carbon is preferably in a range of 0 at% or more and 20 at% or less. As a more preferable range of the content of each of the elements in the protective layer 15 including the tantalum compound, in the element ratio of the entire protective layer 15, the content of tantalum is preferably in a range of 20 at% or more and 80 at% or less, the content of oxygen is preferably in a range of 0 at% or more and 80 at% or less, the content of nitrogen is preferably in a range of 0 at% or more and 60 at% or less, and the content of carbon is preferably in a range of 0 at% or more and 10 at% or less. When the content of each of the elements in the protective layer 15 including the tantalum compound is in the above-described numerical range, the barrier performance of the gas permeation of the protective layer 15 to the graded layer 14 and the phase layer 13 is improved.

In addition, the protective layer 15 including the tungsten compound is a single-layer film that contains tungsten and one or more elements selected from oxygen, nitrogen, and carbon or is a multi-layer film or a graded film thereof.

In the protective layer 15 including the tungsten compound, in an element ratio of the entire protective layer 15, the content of tungsten is preferably in a range of 10 at% or more and 70 at% or less, the content of oxygen is preferably in a range of 30 at% or more and 90 at% or less, the content of nitrogen is preferably in a range of 0 at% or more and 20 at% or less, and the content of carbon is preferably in a range of 0 at% or more and 20 at% or less. As a more preferable range of the content of each of the elements in the protective layer 15 including the tungsten compound, in the element ratio of the entire protective layer 15, the content of tungsten is preferably in a range of 20 at% or more and 60 at% or less, the content of oxygen is preferably in a range of 50 at% or more and 80 at% or less, the content of nitrogen is preferably in a range of 0 at% or more and 10 at% or less, and the content of carbon is preferably in a range of 0 at% or more and 10 at% or less. When the content of each of the elements in the protective layer 15 including the tungsten compound is in the above-described numerical range, the barrier performance of the gas permeation of the protective layer 15 to the graded layer 14 and the phase layer 13 is improved.

In addition, the protective layer 15 including the tellurium compound is a single-layer film that contains tellurium and one or more elements selected from oxygen, nitrogen, and carbon or is a multi-layer film or a graded film thereof.

In the protective layer 15 including the tellurium compound, in an element ratio of the entire protective layer 15, the content of tellurium is preferably in a range of 20 at% or more and 70 at% or less, the content of oxygen is preferably in a range of 30 at% or more and 90 at% or less, the content of nitrogen is preferably in a range of 0 at% or more and 20 at% or less, and the content of carbon is preferably in a range of 0 at% or more and 20 at% or less. As a more preferable range of the content of each of the elements in the protective layer 15 including the tellurium compound, in the element ratio of the entire protective layer 15, the content of tellurium is preferably in a range of 30 at% or more and 60 at% or less, the content of oxygen is preferably in a range of 50 at% or more and 80 at% or less, the content of nitrogen is preferably in a range of 0 at% or more and 10 at% or less, and the content of carbon is preferably in a range of 0 at% or more and 10 at% or less. When the content of each of the elements in the protective layer 15 including the tellurium compound is in the above-described numerical range, the barrier performance of the gas permeation of the protective layer 15 to the graded layer 14 and the phase layer 13 is improved.

In addition, the protective layer 15 including the silicon compound is a single-layer film that contains silicon and one or more elements selected from oxygen, nitrogen, and carbon or is a multi-layer film or a graded film thereof.

In the protective layer 15 including the silicon compound, in an element ratio of the entire protective layer 15, the content of silicon is preferably in a range of 20 at% or more and 70 at% or less, the content of oxygen is preferably in a range of 0 at% or more and 90 at% or less, the content of nitrogen is preferably in a range of 0 at% or more and 60 at% or less, and the content of carbon is preferably in a range of 0 at% or more and 20 at% or less. As a more preferable range of the content of each of the elements in the protective layer 15 including the silicon compound, in the element ratio of the entire protective layer 15, the content of silicon is preferably in a range of 30 at% or more and 60 at% or less, the content of oxygen is preferably in a range of 0 at% or more and 80 at% or less, the content of nitrogen is preferably in a range of 0 at% or more and 40 at% or less, and the content of carbon is preferably in a range of 0 at% or more and 10 at% or less. When the content of each of the elements in the protective layer 15 including the silicon compound is in the above-described numerical range, the barrier performance of the gas permeation of the protective layer 15 to the graded layer 14 and the phase layer 13 is improved.

As described above, when the protective layer 15 is a single-layer film that includes one or more compounds selected from tantalum metal, a tantalum compound, tungsten metal, a tungsten compound, tellurium metal, a tellurium compound, silicon metal, and a silicon compound, a mixed film of the compounds, or a multi-layer film of the compounds, the gas permeation to the graded layer 14 and the phase layer 13 can be effectively prevented.

The film thickness d3 of the protective layer 15 is 15 nm or less as described above. Even when a plurality of the protective layers 15 are provided, the total film thickness thereof only needs to be 15 nm or less, and the film thickness of each of the layers is not particularly limited. When the film thickness d3 of the protective layer 15 is in the above-described numerical range, barrier performance of gas permeation to the graded layer 14 and the phase layer 13 can be maintained while maintaining optical characteristics or modification characteristics.

### <Graded Layer>

The graded layer 14 is formed on the phase layer 13 without another film interposed, and the protective layer 15 is formed on the graded layer 14 without another film interposed. The graded layer 14 is a layer that relaxes a difference in film stress or a difference in modification etching rate between the phase layer 13 and the protective layer 15. In the present embodiment, to prevent a decrease in adhesion force caused by a difference in film stress between the phase layer 13 and the protective layer 15, resistance to film peeling caused by cleaning, that is, interlayer peeling between the phase layer 13 and the protective layer 15 is improved. In addition, a level difference in a pattern cross-section caused by a difference in etching rate decreases. Therefore, the cross-sectional shape of the pattern side surface is linear, and the transfer performance of the phase shift mask is improved.

In addition, the graded layer 14 is preferably a layer that has resistance with respect to oxygen-containing chlorine-based (Cl/O-based) gas etching, is etchable with fluorine-based gas (F-based), and can be modified by an electron beam (EB) modification method.

Regarding the composition of the graded layer 14, a ratio between the composition of the phase layer 13 and the composition of the protective layer 15 continuously changes in the film depth direction, the ratio of the composition of the phase layer 13 in the graded layer 14 decreases from the substrate 11 side toward the protective layer 15 side, and the ratio of the composition of the protective layer 15 in the graded layer 14 increases from the substrate 11 side toward the protective layer 15 side.

"The composition of the phase layer 13" described herein refers to the composition as the compound configuring the phase layer 13, not a ratio of an individual element such as oxygen or nitrogen in the phase layer 13. Likewise, "the composition of the protective layer 15" described herein refers to the composition as the compound configuring the protective layer 15, not a ratio of an individual element such as oxygen or nitrogen in the protective layer 15. That is, regarding the composition of the graded layer 14, a ratio between the content of the component (compound) configuring the phase layer 13 and the content of the component (compound) configuring the protective layer 15 continuously changes in the film depth direction. Specifically, the content ratio of the component configuring the phase layer 13 in the graded layer 14 decreases from the substrate 11 side toward the protective layer 15 side, and the content ratio of the component configuring the protective layer 15 in the graded layer 14 increases from the substrate 11 side toward the protective layer 15 side.

Hereinafter, an aspect of the compositional grading of the graded layer 14 will be described using the drawings.

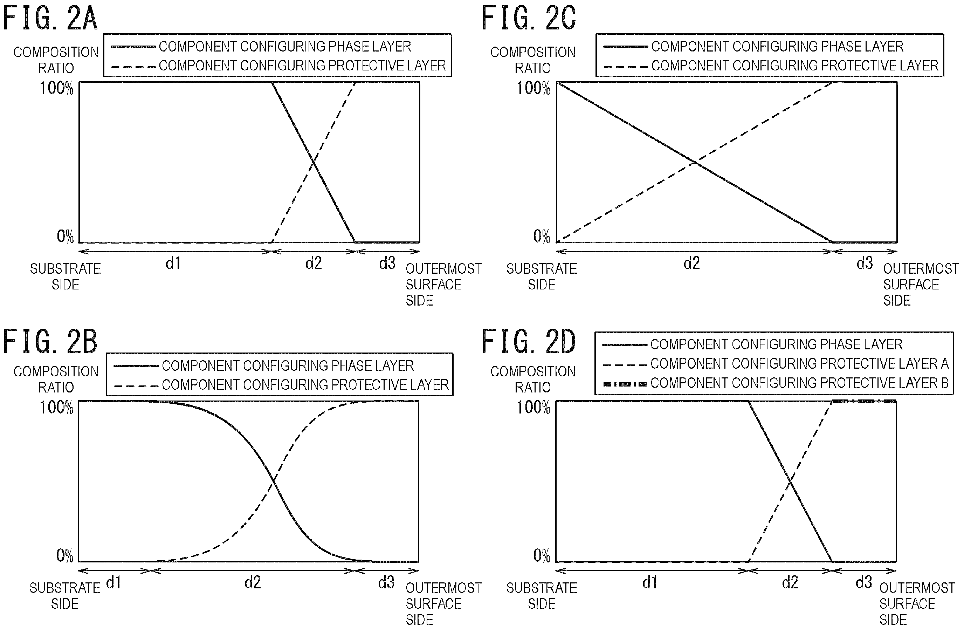

FIGS. 2A to 2D are schematic cross-sectional views schematically illustrating the compositional grading of the graded layer 14 according to the present embodiment, that is, the component ratio. The horizontal axis of FIGS. 2A to 2D represents the distance from the substrate 11 side to the outermost surface of the phase shift film 12, and the vertical axis of FIGS. 2A to 2D represents the composition ratio (component ratio) between the components (compounds) configuring the phase layer 13 and the protective layer 15.

In a first aspect in FIG. 2A, the phase layer 13 is formed with a distance of d1 (hereinafter, simply, referred to as "film thickness") from the substrate 11 side, the graded layer 14 is formed on the phase layer 13 with a thickness of the film thickness d2, and the protective layer 15 is further formed on the graded layer 14 with a thickness of the film thickness d3. At this time, the ratio (content ratio) of the component configuring the phase layer 13 in the graded layer 14 linearly decreases toward the protective layer 15 side, and the ratio (content ratio) of the component configuring the protective layer 15 in the graded layer 14 linearly increases toward the protective layer 15 side.

In addition, in a second aspect of FIG. 2B, as in the first aspect, the phase layer 13 is formed with the film thickness d1 from the substrate 11 side, the graded layer 14 is formed on the phase layer 13 with a thickness of the film thickness d2, and the protective layer 15 is further formed on the graded layer 14 with a thickness of the film thickness d3. Here, in the second aspect, unlike the first aspect, the ratio of the component configuring the phase layer 13 in the graded layer 14 decreases in a curved line toward the protective layer 15 side, and the ratio of the component configuring the protective layer 15 in the graded layer 14 increases in a curved line toward the protective layer 15 side. In both of the first aspect and the second aspect, a film thickness (position) at which the ratio of the component configuring the phase layer 13 and the ratio of the component configuring the protective layer 15 are reversed is arbitrary, and any of a film thickness of the region where the ratio of the component configuring the phase layer 13 is high or a film thickness of the region where the ratio of the component configuring the protective layer 15 is high may be more than the other one.

In addition, in a third aspect of FIG. 2C, a case where the transmittance and the phase difference with respect to the exposure wavelength can be sufficiently adjusted by only the graded layer 14 is illustrated, and the film thickness of the phase layer 13 is 0 nm as a measured value. Although the film thickness of the phase layer 13 in the third aspect is very small, the phase layer 13 itself is present.

Further, in a fourth aspect of FIG. 2D, a case where a plurality of protective layers 15 are provided is illustrated, the graded layer 14 that includes the component configuring the phase layer 13 and a component configuring a protective layer 15A is formed on the phase layer 13, and a protective layer 15B that includes a component different from the component configuring the protective layer 15A is formed on the graded layer 14. This way, the protective layer 15 may have a single-layer structure including one kind of component (compound) or may be a multi-layer structure that includes two or more kinds of components (compounds).

### (Overall Configuration of Phase Shift Mask)

Hereinafter, a configuration of a phase shift mask 100 according to an embodiment of the present invention will be described in detail.

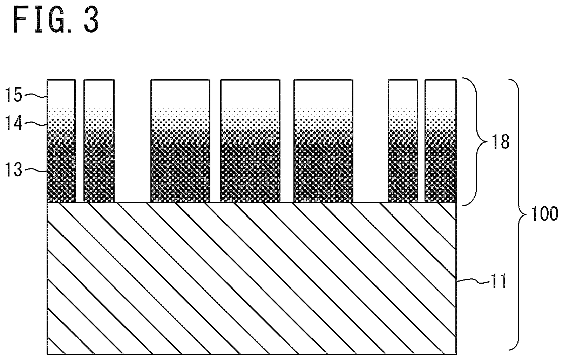

FIG. 3 is a schematic cross-sectional view illustrating a configuration of the phase shift mask according to an embodiment of the present invention. The phase shift mask 100 illustrated in FIG. 3 is a phase shift mask (that is, a patterned phase shift mask) having a circuit pattern to which exposure light having a wavelength of 200 nm or less is applied, the phase shift mask 100 including: a substrate 11 that is transparent with respect to the exposure wavelength; and a phase shift film 12 formed on the substrate 11. In addition, the phase shift film 12 includes at least the phase layer 13 that is capable of adjusting a predetermined amount of each of a phase and a transmittance with respect to exposure light to be transmitted, the protective layer 15 formed on the phase layer 13 and that prevent gas permeation to the phase layer 13, and the graded layer 14 positioned between the phase layer 13 and the protective layer 15 and is a section (region) where a ratio between a composition of the phase layer 13 (a content of a component configuring the phase layer 13) and a composition of the protective layer 15 (a content of a component configuring the protective layer 15) continuously changes in a film depth direction (film thickness direction). In the phase shift film 12, the phase layer 13 is positioned on the substrate 11 side.

In addition, when a film thickness of the phase layer 13 is set to d1, a film thickness of the graded layer 14 is set to d2, and a film thickness of the protective layer 15 is set to d3, it is preferable that a total film thickness of d1 and d2 is more than d3 and d3 is 15 nm or less.

The phase shift mask 100 includes a phase shift film pattern 18 formed by removing a part of the phase shift film 12 to expose the surface of the substrate 11.

The composition and the like of each of the layers configuring the phase shift mask 100 according to the embodiment of the present invention are the same as the composition and the like of each of the layers configuring the phase shift mask blank 10 according to the embodiment of the present invention described above. The detailed description regarding the composition and the like of each of the layers will not be repeated.

### (Method for Manufacturing Phase Shift Mask)

A method for manufacturing the phase shift mask 100 using the phase shift mask blank 10 according to the present embodiment includes: a step of forming a light shielding film 16 on the phase shift film 12; a step of forming a resist pattern 17 on the light shielding film 16 formed on the phase shift film 12; a step of forming a pattern on the light shielding film 16 by oxygen-containing chlorine-based etching (Cl/O-based) after forming the resist pattern 17; a step of forming a pattern on the phase shift film 12 by fluorine-based etching (F-based) after forming the pattern on the light shielding film 16; a step of removing the resist pattern 17 after forming the pattern on the phase shift film 12; and a step of removing the light shielding film 16 by oxygen-containing chlorine-based etching (Cl/O-based) from the phase shift film 12 after removing the resist pattern 17.

Here, the light shielding film 16 according to the embodiment of the present invention will be described.

### <Light Shielding Film>

The light shielding film 16 is a layer formed on the phase shift mask blank 10 (protective layer 15) according to the embodiment of the present invention.

The light shielding film 16 is, for example, a single-layer film including a chromium simple substance or a chromium compound or is a multi-layer film or a graded film thereof. More specifically, the light shielding film 16 including the chromium compound is a single-layer film that contains chromium and one or more elements selected from nitrogen and oxygen or is a multi-layer film or a graded film thereof.

In the light shielding film 16 including the chromium compound, in an element ratio of the entire light shielding film 16, the content of chromium is preferably in a range of 30 at% or more and 100 at% or less, the content of oxygen is preferably in a range of 0 at% or more and 50 at% or less, the content of nitrogen is preferably in a range of 0 at% or more and 50 at% or less, and the content of carbon is preferably in a range of 0 at% or more and 10 at% or less. As a more preferable range of the content of each of the elements in the light shielding film 16 including the chromium compound, in the element ratio of the entire light shielding film 16, the content of chromium is preferably in a range of 50 at% or more and 100 at% or less, the content of oxygen is preferably in a range of 0 at% or more and 40 at% or less, the content of nitrogen is preferably in a range of 0 at% or more and 40 at% or less, and the content of carbon is preferably in a range of 0 at% or more and 5 at% or less. When the content of each of the elements in the light shielding film 16 including the chromium compound is in the above-described numerical range, the light shielding performance of the light shielding film 16 is improved.

A film thickness of the light shielding film 16 is, for example, in a range of 35 nm or more and 80 nm or less and particularly preferably in a range of 40 nm or more and 75 nm or less.

The light shielding film 16 can be formed using a well-known method. Preferable examples of a method for most easily obtaining a film having excellent homogeneity include a sputtering method. The present embodiment is not limited to the sputtering method.

A target and sputtering gas are selected depending on the film composition. For example, as a method for forming a film containing chromium, a method of performing reactive sputtering using a target containing chromium in only inert gas such as argon gas, in only reactive gas such as oxygen, or in mixed gas of inert gas and reactive gas can be performed. The flow rate of the sputtering gas may be adjusted depending on film characteristics, may be uniform during film forming, or when the oxygen content or the nitrogen content is desired to change in a film thickness direction, may change depending on a target composition. In addition, an applied voltage to the target, a distance between the target and the substrate, or an internal pressure of a film forming chamber may be adjusted.

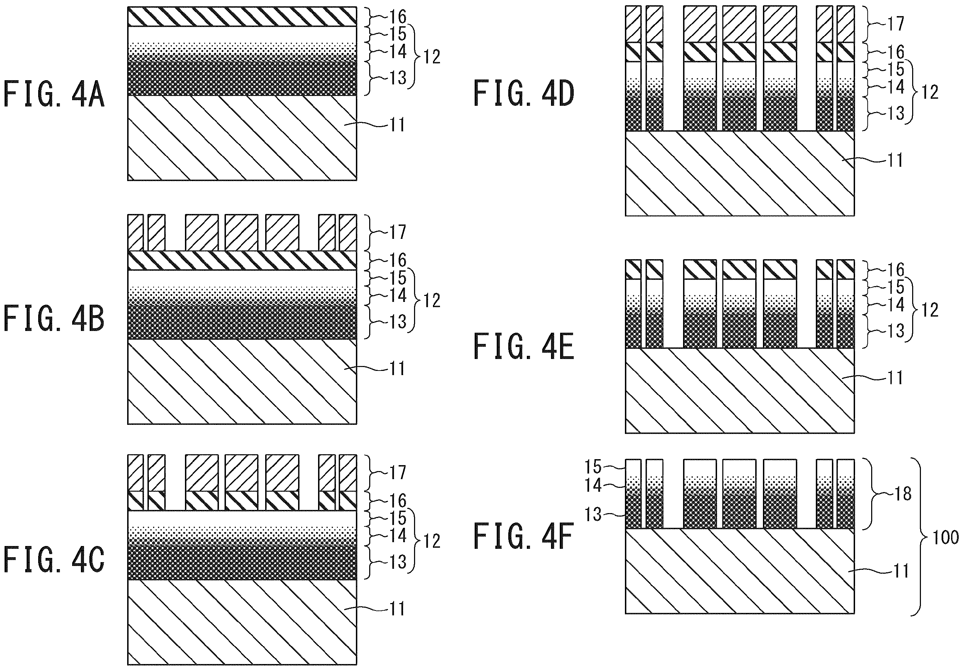

Hereinafter, each of the steps in the method for manufacturing the phase shift mask 100 according to the embodiment of the present invention will be described. FIGS. 4A to 4F are schematic cross-sectional views illustrating steps of manufacturing the phase shift mask 100 using the phase shift mask blank 10 illustrated in FIG. 1. FIG. 4A illustrates a step of forming the light shielding film 16 on the phase shift film 12. FIG. 4B illustrates a step of forming the resist pattern 17 by applying a resist film to the light shielding film 16, drawing a pattern, and developing the pattern. FIG. 4C illustrates a step of patterning the light shielding film 16 along the resist pattern 17 by oxygen-containing chlorine-based dry etching (Cl/O-based). FIG. 4D illustrates a step of forming the phase shift film pattern 18 by patterning the phase shift film 12 along the pattern of the light shielding film 16 by fluorine-based etching (F-based). FIG. 4E illustrates a step of peeling and removing the resist pattern 17 and cleaning the mask. FIG. 4F illustrates a step of removing the light shielding film 16 by oxygen-containing chlorine-based etching (Cl/O-based) from the phase shift film 12 on which the phase shift film pattern 18 is formed. This way, the phase shift mask 100 according to the present embodiment is manufactured.

The phase shift mask 100 according to the present embodiment is a phase shift mask to which exposure light having a wavelength of 200 nm or less is applied, the phase shift mask including: the substrate 11; and the phase shift film 12 formed on the substrate 11 with or without another film interposed. In addition, the phase shift film 12 includes the phase layer 13 that is capable of adjusting a predetermined amount of each of a phase and a transmittance with respect to exposure light to be transmitted, the protective layer 15 formed on the phase layer 13 and that prevent gas permeation to the phase layer 13, and the graded layer 14 positioned between the phase layer 13 and the protective layer 15, which is a section (region) where a ratio between a composition of the phase layer 13 (a content of a component configuring the phase layer 13) and a composition of the protective layer 15 (a content of a component configuring the protective layer 15) continuously changes in a film depth direction (film thickness direction). In the phase shift film 12, the phase layer 13 is positioned on the substrate 11 side. In addition, the phase shift mask 100 includes a phase shift film pattern 18 formed by removing a part of the phase shift film 12 to expose a part of the substrate 11. In addition, when a film thickness of the phase layer 13 is set to d1, a film thickness of the graded layer 14 is set to d2, and a film thickness of the protective layer 15 is set to d3, it is preferable that a total film thickness of d1 and d2 is more than d3 and d3 is 15 nm or less.

In the step of FIG. 4B, as a material of the resist film, a positive resist or a negative resist can also be used. However, a chemically amplified resist for electron beam drawing capable of forming a high accuracy pattern is preferably used. A film thickness of the resist film is, for example, in a range of 50 nm or more and 250 nm or less. In particular, when a phase shift mask required for forming a fine pattern is produced, the film thickness of the resist film needs to be small and is preferably 200 nm or less such that an aspect ratio of the resist pattern 17 does not increase to prevent pattern collapse. On the other hand, the lower limit of the film thickness of the resist film is determined in comprehensive consideration of conditions such as the etching resistance of the resist material to be used and is preferably 60 nm or more. When a chemically amplified resist for electron beam drawing is used as a resist film, an energy density of an electron beam during drawing is in a range of 35 µC/cm² to 100 µC/cm², and by performing a heat treatment and a development treatment after the drawing, the resist pattern 17 is obtained.

In addition, in the step of FIG. 4E, the peeling and removal of the resist pattern 17 may be wet peeling using a peeling solution or may be dry peeling by dry etching.

In addition, in the step of FIG. 4C, as conditions of the oxygen-containing chlorine-based dry etching (Cl/O-based) for patterning the light shielding film 16 including a chromium simple substance or a chromium compound, well-known conditions that have been used for removing the chromium compound film may be used, and the chlorine gas and the oxygen gas may be optionally mixed with inert gas such as nitrogen gas or helium gas. The phase shift film 12 positioned below the light shielding film 16 has resistance to the oxygen-containing chlorine-based dry etching (Cl/O-based) and thus remains without being removed or patterned in the present step.

In addition, in the step of FIG. 4D, as conditions of the fluorine-based dry etching (F-based) for patterning the phase shift film 12, well-known conditions that have been used for dry etching a silicon-based compound film, a tantalum compound film, a molybdenum compound film, or the like may be used, CF₄, C₂F₆, or SF₆ is generally used as the fluorine-based gas, and the fluorine-based gas may be optionally mixed with active gas such as oxygen or inert gas such as nitrogen gas or helium gas. In FIG. 4D, the light shielding film 16 or the resist pattern 17 positioned above the phase shift film 12 has resistance to the fluorine-based dry etching (F-based) and thus remains without being removed or patterned in the present step. In FIG. 4D, the substrate 11 is dug by about 1 nm to 3 nm to prevent the removal defect of the phase shift film 12, and the phase difference is finely adjusted in general.

In addition, in the step of FIG. 4F, as conditions of the oxygen-containing chlorine-based dry etching (Cl/O-based) for removing the light shielding film 16, well-known conditions that have been used for removing the chromium compound film may be used, and the chlorine gas and the oxygen gas may be optionally mixed with inert gas such as nitrogen gas or helium gas. Both of the phase shift film 12 and the substrate 11 positioned below the light shielding film 16 have resistance to the oxygen-containing chlorine-based dry etching (Cl/O-based) and thus remain without being removed or patterned in the present step.

### [Examples]

Hereinafter, the embodiments of the present invention will be described in more detail using Examples. However, the present invention is not limited to the following examples.

### (Example 1)

Using a multi-source DC sputtering apparatus using three targets, a phase layer including silicon, molybdenum, oxygen, and nitrogen having a thickness of 63 nm was formed on a quartz substrate. Molybdenum and silicon were used as the targets, and argon, oxygen, and nitrogen were used as the sputtering gas.

Next, the amount of nitrogen introduced was gradually weakened while gradually weakening an applied voltage to the silicon target and the molybdenum target, and a graded layer having a thickness of 8 nm was formed on the phase layer while gradually strengthening an applied voltage to the tantalum target.

Next, the voltage application to the silicon target and the molybdenum target was stopped, and by continuing the voltage application to the tantalum target while introducing argon and oxygen, a protective layer having a thickness of 2 nm was formed on the graded layer.

When the obtained phase shift film was analyzed by ESCA, Si:Mo:O:N = 30:5:20:45 (at% ratio) in a region from the substrate side to a position of 63 nm. Next, from the phase layer side toward the protective layer side, each of ratios of silicon atoms, molybdenum atoms, and nitrogen atoms continuously decreased at a thickness of 8 nm, and each of the ratios of tantalum atoms and oxygen atoms continuously increased at a thickness of 8 nm. Next, Ta:O = 30:70 (at% ratio) at a thickness of 2 nm. That is, when the phase shift film according to Example 1 was analyzed by ESCA, the composition ratio of the phase layer was Si:Mo:O:N = 30:5:20:45 (at% ratio). In addition, each of the ratios of silicon atoms, molybdenum atoms, and nitrogen atoms in the graded layer continuously and linearly decreased from the phase layer side toward the protective layer side. In addition, each of the ratios of tantalum atoms and oxygen atoms in the graded layer continuously and linearly increased from the phase layer side toward the protective layer side. Further, the composition ratio of the protective layer was Ta:O = 30:70 (at% ratio).

In the formed phase shift film including the phase layer, the graded layer, and the protective layer, the transmittance with respect to the exposure light was 6%, and the phase difference was 180 degrees.

Next, using the DC sputtering apparatus, a light shielding film including chromium, oxygen, and nitrogen having a thickness of 50 nm was formed on the protective layer. Chromium was used as the target, and argon, oxygen, and nitrogen were used as the sputtering gas. When the composition of the light shielding film was analyzed by ESCA, the composition was Cr:O:N = 55:35:10 (at% ratio).

Next, a negative chemically amplified electron beam resist having a film thickness of 200 nm was spin-coated on the light shielding film, and a pattern was drawn with an electron beam at a dosage of 35 µC/cm², was heated at 110°C for 10 minutes, and was developed by puddle development for 90 seconds to form a resist pattern.

Next, using the dry etching apparatus, the light shielding film was patterned. Chlorine, oxygen, and helium were used as the etching gas, the gas pressure was set to 5 mTorr, the ICP power was set to 400 W, and the bias power was set to 40 W. Overetching was performed by 100%.

Next, using the dry etching apparatus, the phase shift film including the protective layer, the graded layer, and the phase layer was patterned. CF₄ and oxygen were used as the etching gas, the gas pressure was set to 5 mTorr, the ICP power was set to 400 W, and the bias power was set to 40 W. When the quartz substrate was dug by 3 nm on average, the dry etching was stopped.

Next, the resist pattern was peeled and cleaned by sulfuric acid-hydrogen peroxide mixture cleaning.

Next, using the dry etching apparatus, the light shielding film was removed. Chlorine, oxygen, and helium were used as the etching gas, the gas pressure was set to 10 mTorr, the ICP power was set to 500 W, and the bias power was set to 10 W. Overetching was performed by 200%. At this time, the phase shift film and the quartz substrate positioned below the light shielding film was not damaged.

This way, a phase shift mask according to Example 1 was obtained.

Next, the phase shift mask pattern was modified by EB modification.

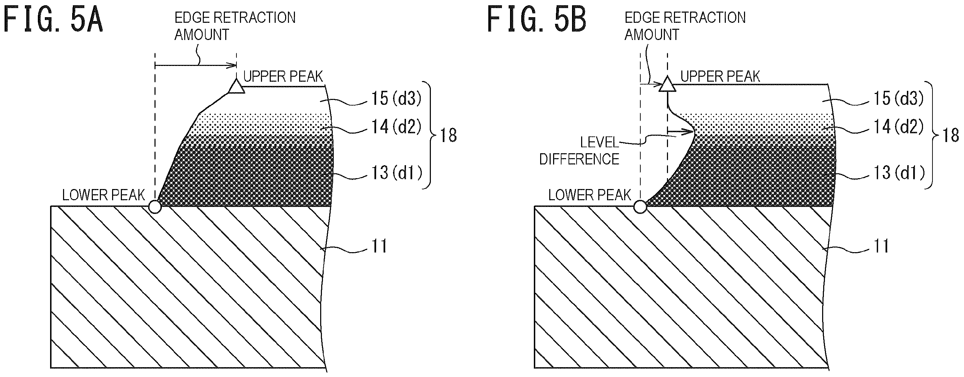

FIGS. 5A and 5B are diagrams schematically illustrating one side of a cross-section of the phase shift film pattern after the EB modification. Regarding an edge of the phase shift film pattern after the EB modification, since there was a difference in modification etching rate between the phase layer, the graded layer, and the protective layer, a level difference may be generated on a side surface of the phase shift film pattern. In the present example, as illustrated in FIGS. 5A and 5B, when a peak of the phase shift film pattern on the substrate side is set to a lower peak and a peak of the phase shift film pattern on the outermost surface side was set to an upper peak, the length by which the upper peak retracted from the lower peak toward the inside of the phase shift film pattern was set to "edge retraction amount", and the length by which the upper peak retracted from the upper peak toward the inside was set to "level difference amount".

FIG. 5A is a schematic diagram illustrating a modified cross-section of the phase shift mask according to Example 1. In the phase shift film pattern according to Example 1, the upper peak retracted from the lower peak toward the inside of the phase shift film pattern, and the edge retraction amount was 14 nm. In addition, the level difference amount of the phase shift film pattern according to Example 1 was 0 nm.

Regarding "the edge retraction amount" and "the level difference amount", as the value decreases, the transfer performance becomes higher. In the present example, when the edge retraction amount is set to "x" and the level difference amount is set to "y", as long as the sum (x + y) is less than 20 nm, it can be said that there is no problem in the transfer performance, and the transfer performance of the phase shift mask is very high. On the other hand, when the sum (x + y) is 20 nm or more, there is a problem from the viewpoint of the transfer performance.

It was verified from the above-described measurement result that, in the phase shift mask according to Example 1, since the edge retraction amount x is 14 nm and the level difference amount y is 0 nm, the sum (x + y) of the edge retraction amount x and the level difference amount y is 14 nm, and the transfer performance is excellent.

Next, regarding the phase shift mask, a dosage at which the haze was formed by accelerated exposure was measured and was 110 kJ/cm².

Regarding "the dosage at which the haze was formed by accelerated exposure, as the value increases, the haze is not likely to be formed. It can be said that, when the dosage is 70 kJ/cm² or more, there are no problems in using the phase shift mask, when the dosage is 100 kJ/cm² or more, the haze is not likely to be formed in the phase shift mask.

It was verified from the above-described measurement result, in the phase shift mask according to Example 1, the dosage is 110 kJ/cm², and thus the formation of haze can be reduced.

### (Example 2)

Using a multi-source DC sputtering apparatus using three targets, a phase layer including silicon, molybdenum, oxygen, and nitrogen having a thickness of 66 nm was formed on a quartz substrate. Molybdenum and silicon were used as the targets, and argon, oxygen, and nitrogen were used as the sputtering gas.

Next, the amount of nitrogen introduced was gradually weakened while gradually weakening an applied voltage to the silicon target and the molybdenum target, and a graded layer having a thickness of 8 nm was formed on the phase layer while gradually strengthening an applied voltage to the tungsten target.

Next, the voltage application to the silicon target and the molybdenum target was stopped, and by continuing the voltage application to the tungsten target while introducing argon and oxygen, a protective layer having a thickness of 2 nm was formed on the graded layer.

When the obtained phase shift film was analyzed by ESCA, Si:Mo:O:N = 35:5:15:45 (at% ratio) in a region from the substrate side to a position of 66 nm. Next, from the phase layer side to the protective layer side, each of ratios of silicon atoms, molybdenum atoms, and nitrogen atoms continuously decreased at a thickness of 8 nm, and each of the ratios of tungsten atoms and oxygen atoms continuously increased at a thickness of 8 nm. Next, W:O = 25:75 (at% ratio) at a thickness of 2 nm. Next, when the phase shift film according to Example 2 was analyzed by ESCA, the composition ratio of the phase layer was Si:Mo:O:N = 35:5:15:45 (at% ratio). In addition, each of the ratios of silicon atoms, molybdenum atoms, and nitrogen atoms in the graded layer continuously and linearly decreased from the phase layer side toward the protective layer side. In addition, each of the ratios of tungsten atoms and oxygen atoms in the graded layer continuously and linearly increased from the phase layer side toward the protective layer side. Further, the composition ratio of the protective layer was W:O = 25:75 (at% ratio).

In the formed phase shift film including the phase layer, the graded layer, and the protective layer, the transmittance with respect to the exposure light was 6%, and the phase difference was 180 degrees.

Next, using the DC sputtering apparatus, a light shielding film including chromium, oxygen, and nitrogen having a thickness of 50 nm was formed on the protective layer. Chromium was used as the target, and argon, oxygen, and nitrogen were used as the sputtering gas. When the composition of the light shielding film was analyzed by ESCA, the composition was Cr:O:N = 55:35:10 (at% ratio).

Next, a negative chemically amplified electron beam resist having a film thickness of 200 nm was spin-coated on the light shielding film, and a pattern was drawn with an electron beam at a dosage of 35 µC/cm², was heated at 110°C for 10 minutes, and was developed by puddle development for 90 seconds to form a resist pattern.

Next, using the dry etching apparatus, the light shielding film was patterned. Chlorine, oxygen, and helium were used as the etching gas, the gas pressure was set to 5 mTorr, the ICP power was set to 400 W, and the bias power was set to 40 W. Overetching was performed by 100%.

Next, using the dry etching apparatus, the phase shift film including the protective layer, the graded layer, and the phase layer was patterned. CF₄ and oxygen were used as the etching gas, the gas pressure was set to 5 mTorr, the ICP power was set to 400 W, and the bias power was set to 40 W. When the quartz substrate was dug by 3 nm on average, the dry etching was stopped.

Next, the resist pattern was peeled and cleaned by sulfuric acid-hydrogen peroxide mixture cleaning.

Next, using the dry etching apparatus, the light shielding film was removed. Chlorine, oxygen, and helium were used as the etching gas, the gas pressure was set to 10 mTorr, the ICP power was set to 500 W, and the bias power was set to 10 W. Overetching was performed by 200%. At this time, the phase shift film and the quartz substrate positioned below the light shielding film was not damaged.

This way, a phase shift mask according to Example 2 was obtained.

Next, the phase shift mask pattern was modified by EB modification. When a cross-sectional shape of the phase shift film pattern was observed, the edge was as illustrated in FIG. 5A, and the edge retraction amount was 15 nm. In addition, the level difference amount of the phase shift film pattern according to Example 2 was 0 nm.

Next, regarding the phase shift mask, a dosage at which the haze was formed by accelerated exposure was measured and was 80 kJ/cm².

It was verified from the above-described measurement result, in the phase shift mask according to Example 2, the dosage is 80 kJ/cm², and thus the formation of haze can be reduced.

In addition, it was verified from the above-described measurement result that, in the phase shift mask according to Example 2, since the edge retraction amount x is 15 nm and the level difference amount y is 0 nm, the sum (x + y) of the edge retraction amount x and the level difference amount y is 15 nm, and the transfer performance is excellent.

### (Example 3)

Using a multi-source DC sputtering apparatus using three targets, a phase layer including silicon, molybdenum, oxygen, and nitrogen having a thickness of 66 nm was formed on a quartz substrate. Molybdenum and silicon were used as the targets, and argon, oxygen, and nitrogen were used as the sputtering gas.

Next, the amount of nitrogen introduced was gradually weakened while gradually weakening an applied voltage to the silicon target and the molybdenum target, and a graded layer having a thickness of 8 nm was formed on the phase layer while gradually strengthening an applied voltage to the tellurium target.

Next, the voltage application to the silicon target and the molybdenum target was stopped, and by continuing the voltage application to the tellurium target while introducing argon and oxygen, a protective layer having a thickness of 2 nm was formed on the graded layer.

When the obtained phase shift film was analyzed by ESCA, Si:Mo:O:N = 40:8:7:45 (at% ratio) in a region from the substrate side to a position of 66 nm. Next, from the phase layer side to the protective layer side, each of ratios of silicon atoms, molybdenum atoms, and nitrogen atoms continuously decreased at a thickness of 8 nm, and each of the ratios of tellurium atoms and oxygen atoms continuously increased at a thickness of 8 nm. Next, Te:O = 35:65 (at% ratio) at a thickness of 2 nm. Next, when the phase shift film according to Example 3 was analyzed by ESCA, the composition ratio of the phase layer was Si:Mo:O:N = 40:8:7:45 (at% ratio). In addition, each of the ratios of silicon atoms, molybdenum atoms, and nitrogen atoms in the graded layer continuously and linearly decreased from the phase layer side toward the protective layer side. In addition, each of the ratios of tellurium atoms and oxygen atoms in the graded layer continuously and linearly increased from the phase layer side toward the protective layer side. Further, the composition ratio of the protective layer was Te:O = 35:65 (at% ratio).

In the formed phase shift film including the phase layer, the graded layer, and the protective layer, the transmittance with respect to the exposure light was 6%, and the phase difference was 180 degrees.

Next, using the DC sputtering apparatus, a light shielding film including chromium, oxygen, and nitrogen having a thickness of 50 nm was formed on the protective layer. Chromium was used as the target, and argon, oxygen, and nitrogen were used as the sputtering gas. When the composition of the light shielding film was analyzed by ESCA, the composition was Cr:O:N = 55:35:10 (at% ratio).

Next, a negative chemically amplified electron beam resist having a film thickness of 200 nm was spin-coated on the light shielding film, and a pattern was drawn with an electron beam at a dosage of 35 µC/cm², was heated at 110°C for 10 minutes, and was developed by puddle development for 90 seconds to form a resist pattern.

Next, using the dry etching apparatus, the light shielding film was patterned. Chlorine, oxygen, and helium were used as the etching gas, the gas pressure was set to 5 mTorr, the ICP power was set to 400 W, and the bias power was set to 40 W. Overetching was performed by 100%.

Next, using the dry etching apparatus, the phase shift film including the protective layer, the graded layer, and the phase layer was patterned. CF₄ and oxygen were used as the etching gas, the gas pressure was set to 5 mTorr, the ICP power was set to 400 W, and the bias power was set to 40 W. When the quartz substrate was dug by 3 nm on average, the dry etching was stopped.

Next, the resist pattern was peeled and cleaned by sulfuric acid-hydrogen peroxide mixture cleaning.

Next, using the dry etching apparatus, the light shielding film was removed. Chlorine, oxygen, and helium were used as the etching gas, the gas pressure was set to 10 mTorr, the ICP power was set to 500 W, and the bias power was set to 10 W. Overetching was performed by 200%. At this time, the phase shift film and the quartz substrate positioned below the light shielding film was not damaged.

This way, a phase shift mask according to Example 3 was obtained.

Next, the phase shift mask pattern was modified by EB modification. When a cross-sectional shape of the phase shift film pattern was observed, the edge was as illustrated in FIG. 5A, and the edge retraction amount was 14 nm. In addition, the level difference amount of the phase shift film pattern according to Example 3 was 0 nm.

In addition, it was verified from the above-described measurement result that, in the phase shift mask according to Example 3, since the edge retraction amount x is 14 nm and the level difference amount y is 0 nm, the sum (x + y) of the edge retraction amount x and the level difference amount y is 14 nm, and the transfer performance is excellent.

Next, regarding the phase shift mask, a dosage at which the haze was formed by accelerated exposure was measured and was 75 kJ/cm².

It was verified from the above-described measurement result, in the phase shift mask according to Example 3, the dosage is 75 kJ/cm², and thus the formation of haze can be reduced.

### (Example 4)

Using a multi-source DC sputtering apparatus using two targets, a phase layer including silicon, molybdenum, oxygen, and nitrogen having a thickness of 63 nm was formed on a quartz substrate. Molybdenum and silicon were used as the targets, and argon, oxygen, and nitrogen were used as the sputtering gas.

Next, a graded layer having a thickness of 5 nm was formed on the phase layer while gradually weakening an applied voltage to the molybdenum target.

Next, the voltage application to the molybdenum target was stopped, and a protective layer having a thickness of 8 nm was formed on the graded layer.

When the obtained phase shift film was analyzed by ESCA, Si:Mo:O:N = 30:5:20:45 (at% ratio) in a region from the substrate side to a position of 63 nm. Next, from the phase layer side to the protective layer side, each of ratios of molybdenum atoms and nitrogen atoms continuously decreased at a thickness of 5 nm, and each of the ratios of silicon atoms and oxygen atoms continuously increased at a thickness of 5 nm. Next, Si:O:N = 40:40:20 (at% ratio) at a thickness of 8 nm. Next, when the phase shift film according to Example 4 was analyzed by ESCA, the composition ratio of the phase layer was Si:Mo:O:N = 30:5:20:45 (at% ratio). In addition, each of the ratios of molybdenum atoms and nitrogen atoms in the graded layer continuously and linearly decreased from the phase layer side toward the protective layer side. In addition, each of the ratios of silicon atoms and oxygen atoms in the graded layer continuously and linearly increased from the phase layer side toward the protective layer side. Further, the composition ratio of the protective layer was Si:O:N = 40:40:20 (at% ratio).

In the formed phase shift film including the phase layer, the graded layer, and the protective layer, the transmittance with respect to the exposure light was 7%, and the phase difference was 180 degrees.

Next, using the DC sputtering apparatus, a light shielding film including chromium, oxygen, and nitrogen having a thickness of 50 nm was formed on the protective layer. Chromium was used as the target, and argon, oxygen, and nitrogen were used as the sputtering gas. When the composition of the light shielding film was analyzed by ESCA, the composition was Cr:O:N = 55:35:10 (at% ratio).

Next, a negative chemically amplified electron beam resist having a film thickness of 200 nm was spin-coated on the light shielding film, and a pattern was drawn with an electron beam at a dosage of 35 µC/cm², was heated at 110°C for 10 minutes, and was developed by puddle development for 90 seconds to form a resist pattern.

Next, using the dry etching apparatus, the light shielding film was patterned. Chlorine, oxygen, and helium were used as the etching gas, the gas pressure was set to 5 mTorr, the ICP power was set to 400 W, and the bias power was set to 40 W. Overetching was performed by 100%.

Next, using the dry etching apparatus, the phase shift film including the protective layer, the graded layer, and the phase layer was patterned. CF₄ and oxygen were used as the etching gas, the gas pressure was set to 5 mTorr, the ICP power was set to 400 W, and the bias power was set to 40 W. When the quartz substrate was dug by 3 nm on average, the dry etching was stopped.

Next, the resist pattern was peeled and cleaned by sulfuric acid-hydrogen peroxide mixture cleaning.

Next, using the dry etching apparatus, the light shielding film was removed. Chlorine, oxygen, and helium were used as the etching gas, the gas pressure was set to 10 mTorr, the ICP power was set to 500 W, and the bias power was set to 10 W. Overetching was performed by 200%. At this time, the phase shift film and the quartz substrate positioned below the light shielding film was not damaged.

This way, a phase shift mask according to Example 4 was obtained.

Next, the phase shift mask pattern was modified by EB modification. When a cross-sectional shape of the phase shift film pattern was observed, the edge was as illustrated in FIG. 5B, and the edge retraction amount was 5 nm. In addition, the level difference amount of the phase shift film pattern according to Example 4 was 5 nm.

Next, regarding the phase shift mask, a dosage at which the haze was formed by accelerated exposure was measured and was 130 kJ/cm².

It was verified from the above-described measurement result, in the phase shift mask according to Example 4, the dosage is 130 kJ/cm², and thus the formation of haze can be reduced.

In addition, it was verified from the above-described measurement result that, in the phase shift mask according to Example 4, since the edge retraction amount x is 5 nm and the level difference amount y is 5 nm, the sum (x + y) of the edge retraction amount x and the level difference amount y is 10 nm, and the transfer performance is excellent.

### (Example 5)

Using a multi-source DC sputtering apparatus using three targets, a phase layer including silicon, molybdenum, oxygen, and nitrogen having a thickness of 61 nm was formed on a quartz substrate. Molybdenum and silicon were used as the targets, and argon, oxygen, and nitrogen were used as the sputtering gas.

Next, the amount of nitrogen introduced was gradually weakened while gradually weakening an applied voltage to the silicon target and the molybdenum target, the amount of oxygen introduced was gradually strengthened while gradually strengthening an applied voltage to the tantalum target, and a graded layer having a thickness of 5 nm was formed on the phase layer.

Next, the voltage application to the molybdenum target was stopped, and by continuing the voltage application to the silicon target and the tantalum target while introducing argon, oxygen, and nitrogen, a protective layer having a thickness of 8 nm was formed on the graded layer.

When the obtained phase shift film was analyzed by ESCA, Si:Mo:O:N = 30:5:20:45 (at% ratio) in a region from the substrate side to a position of 61 nm. Next, from the phase layer side toward the protective layer side, each of ratios of silicon atoms, molybdenum atoms, and nitrogen atoms continuously decreased at a thickness of 5 nm, and each of the ratios of tantalum atoms and oxygen atoms continuously increased at a thickness of 5 nm. Next, Si:Ta:O:N = 20:20:40:20 (at% ratio) at a thickness of 8 nm. Next, when the phase shift film according to Example 5 was analyzed by ESCA, the composition ratio of the phase layer was Si:Mo:O:N = 30:5:20:45 (at% ratio). In addition, each of the ratios of silicon atoms, molybdenum atoms, and nitrogen atoms in the graded layer continuously and linearly decreased from the phase layer side toward the protective layer side. In addition, each of the ratios of tantalum atoms and oxygen atoms in the graded layer continuously and linearly increased from the phase layer side toward the protective layer side. Further, the composition ratio of the protective layer was Si:Ta:O:N = 20:20:40:20 (at% ratio).

In the formed phase shift film including the phase layer, the graded layer, and the protective layer, the transmittance with respect to the exposure light was 6%, and the phase difference was 180 degrees.

Next, using the DC sputtering apparatus, a light shielding film including chromium, oxygen, and nitrogen having a thickness of 50 nm was formed on the protective layer. Chromium was used as the target, and argon, oxygen, and nitrogen were used as the sputtering gas. When the composition of the light shielding film was analyzed by ESCA, the composition was Cr:O:N = 55:35:10 (at% ratio).

Next, a negative chemically amplified electron beam resist having a film thickness of 200 nm was spin-coated on the light shielding film, and a pattern was drawn with an electron beam at a dosage of 35 µC/cm², was heated at 110°C for 10 minutes, and was developed by puddle development for 90 seconds to form a resist pattern.

Next, using the dry etching apparatus, the light shielding film was patterned. Chlorine, oxygen, and helium were used as the etching gas, the gas pressure was set to 5 mTorr, the ICP power was set to 400 W, and the bias power was set to 40 W. Overetching was performed by 100%.

Next, using the dry etching apparatus, the phase shift film including the protective layer, the graded layer, and the phase layer was patterned. CF₄ and oxygen were used as the etching gas, the gas pressure was set to 5 mTorr, the ICP power was set to 400 W, and the bias power was set to 40 W. When the quartz substrate was dug by 3 nm on average, the dry etching was stopped.

Next, the resist pattern was peeled and cleaned by sulfuric acid-hydrogen peroxide mixture cleaning.

Next, using the dry etching apparatus, the light shielding film was removed. Chlorine, oxygen, and helium were used as the etching gas, the gas pressure was set to 10 mTorr, the ICP power was set to 500 W, and the bias power was set to 10 W. Overetching was performed by 200%. At this time, the phase shift film and the quartz substrate positioned below the light shielding film was not damaged.

This way, a phase shift mask according to Example 5 was obtained.

Next, the phase shift mask pattern was modified by EB modification. When a cross-sectional shape of the phase shift film pattern was observed, the edge was as illustrated in FIG. 5B, and the edge retraction amount was 12 nm. In addition, the level difference amount of the phase shift film pattern according to Example 5 was 5 nm.

Next, regarding the phase shift mask, a dosage at which the haze was formed by accelerated exposure was measured and was 150 kJ/cm².

It was verified from the above-described measurement result, in the phase shift mask according to Example 5, the dosage is 150 kJ/cm², and thus the formation of haze can be reduced.

In addition, it was verified from the above-described measurement result that, in the phase shift mask according to Example 5, since the edge retraction amount x is 12 nm and the level difference amount y is 5 nm, the sum (x + y) of the edge retraction amount x and the level difference amount y is 17 nm, and the transfer performance is excellent.

### (Example 6)

Using a multi-source DC sputtering apparatus using three targets, a phase layer including silicon, molybdenum, oxygen, and nitrogen having a thickness of 63 nm was formed on a quartz substrate. Molybdenum and silicon were used as the targets, and argon, oxygen, and nitrogen were used as the sputtering gas.

Next, the amount of nitrogen introduced was gradually weakened while gradually weakening an applied voltage between the molybdenum target in a state where the voltage application to the silicon target was maintained, the amount of oxygen introduced was gradually strengthened while gradually strengthening an applied voltage to the tantalum target, and a graded layer having a thickness of 5 nm was formed on the phase layer.

Next, the voltage application to the tantalum target was stopped, and by continuing the voltage application to the silicon target while introducing argon, oxygen, and nitrogen, a protective layer having a thickness of 8 nm was formed on the graded layer.

When the obtained phase shift film was analyzed by ESCA, Si:Mo:O:N = 30:5:20:45 (at% ratio) in a region from the substrate side to a position of 63 nm. Next, from the phase layer side toward the protective layer side, each of ratios of silicon atoms, molybdenum atoms, and nitrogen atoms continuously decreased at a thickness of 5 nm, and each of the ratios of tantalum atoms and oxygen atoms continuously increased at a thickness of 5 nm. Next, Si:O:N = 40:40:20 (at% ratio) at a thickness of 8 nm. Next, when the phase shift film according to Example 6 was analyzed by ESCA, the composition ratio of the phase layer was Si:Mo:O:N = 30:5:20:45 (at% ratio). In addition, each of the ratios of silicon atoms, molybdenum atoms, and nitrogen atoms in the graded layer continuously and linearly decreased from the phase layer side toward the protective layer side. In addition, each of the ratios of tantalum atoms and oxygen atoms in the graded layer continuously and linearly increased from the phase layer side toward the protective layer side. Further, the composition ratio of the protective layer was Si:O:N = 40:40:20 (at% ratio). The composition ratio of the outermost surface of the graded layer, that is, the composition ratio of an interfacial region between the graded layer and the protective layer was Ta:Si:O:N = 20:20:40:20 (at% ratio). Here, in the table, the interfacial region between the graded layer and the protective layer having the above-described composition is shown as "protective layer 1", and the film thickness thereof was very small and is shown as 0 nm as a value.

In the formed phase shift film including the phase layer, the graded layer, and the protective layer, the transmittance with respect to the exposure light was 6%, and the phase difference was 180 degrees.

Next, using the DC sputtering apparatus, a light shielding film including chromium, oxygen, and nitrogen having a thickness of 50 nm was formed on the protective layer. Chromium was used as the target, and argon, oxygen, and nitrogen were used as the sputtering gas. When the composition of the light shielding film was analyzed by ESCA, the composition was Cr:O:N = 55:35:10 (at% ratio).

Next, a negative chemically amplified electron beam resist having a film thickness of 200 nm was spin-coated on the light shielding film, and a pattern was drawn with an electron beam at a dosage of 35 µC/cm², was heated at 110°C for 10 minutes, and was developed by puddle development for 90 seconds to form a resist pattern.

Next, using the dry etching apparatus, the light shielding film was patterned. Chlorine, oxygen, and helium were used as the etching gas, the gas pressure was set to 5 mTorr, the ICP power was set to 400 W, and the bias power was set to 40 W. Overetching was performed by 100%.

Next, using the dry etching apparatus, the phase shift film including the protective layer, the graded layer, and the phase layer was patterned. CF₄ and oxygen were used as the etching gas, the gas pressure was set to 5 mTorr, the ICP power was set to 400 W, and the bias power was set to 40 W. When the quartz substrate was dug by 3 nm on average, the dry etching was stopped.

Next, the resist pattern was peeled and cleaned by sulfuric acid-hydrogen peroxide mixture cleaning.

Next, using the dry etching apparatus, the light shielding film was removed. Chlorine, oxygen, and helium were used as the etching gas, the gas pressure was set to 10 mTorr, the ICP power was set to 500 W, and the bias power was set to 10 W. Overetching was performed by 200%. At this time, the phase shift film and the quartz substrate positioned below the light shielding film was not damaged.

This way, a phase shift mask according to Example 6 was obtained.

Next, the phase shift mask pattern was modified by EB modification. When a cross-sectional shape of the phase shift film pattern was observed, the edge was as illustrated in FIG. 5B, and the edge retraction amount was 7 nm. In addition, the level difference amount of the phase shift film pattern according to Example 6 was 7 nm.

Next, regarding the phase shift mask, a dosage at which the haze was formed by accelerated exposure was measured and was 140 kJ/cm².

It was verified from the above-described measurement result, in the phase shift mask according to Example 6, the dosage is 140 kJ/cm², and thus the formation of haze can be reduced.

In addition, it was verified from the above-described measurement result that, in the phase shift mask according to Example 6, since the edge retraction amount x is 7 nm and the level difference amount y is 7 nm, the sum (x + y) of the edge retraction amount x and the level difference amount y is 14 nm, and the transfer performance is excellent.

### [Comparative Examples]

### (Comparative Example 1)

Using a multi-source DC sputtering apparatus using three targets, a phase layer including silicon, molybdenum, oxygen, and nitrogen having a thickness of 65 nm was formed on a quartz substrate. Molybdenum and silicon were used as the targets, and argon, oxygen, and nitrogen were used as the sputtering gas.

Next, the voltage application to the silicon target and the molybdenum target was stopped, and by continuing the voltage application to the tantalum target while introducing argon and oxygen, a protective layer having a thickness of 8 nm was formed on the phase layer. That is, in Comparative Example 1, the graded layer was not formed.

When the obtained phase shift film was analyzed by ESCA, Si:Mo:O:N = 30:5:20:45 (at% ratio) in a region from the substrate side to a position of 65 nm. Next, Ta:O = 30:70 (at% ratio) at a thickness of 8 nm. Next, when the phase shift film according to Comparative Example 1 was analyzed by ESCA, the composition ratio of the phase layer was Si:Mo:O:N = 30:5:20:45 (at% ratio). In addition, the composition ratio of the protective layer was Ta:O = 30:70 (at% ratio).

In the formed phase shift film including the phase layer and the protective layer, the transmittance with respect to the exposure light was 6%, and the phase difference was 180 degrees.

Next, using the DC sputtering apparatus, a light shielding film including chromium, oxygen, and nitrogen having a thickness of 50 nm was formed on the protective layer. Chromium was used as the target, and argon, oxygen, and nitrogen were used as the sputtering gas. When the composition of the light shielding film was analyzed by ESCA, the composition was Cr:O:N = 55:35:10 (at% ratio).

Next, a negative chemically amplified electron beam resist having a film thickness of 200 nm was spin-coated on the light shielding film, and a pattern was drawn with an electron beam at a dosage of 35 µC/cm², was heated at 110°C for 10 minutes, and was developed by puddle development for 90 seconds to form a resist pattern.

Next, using the dry etching apparatus, the light shielding film was patterned. Chlorine, oxygen, and helium were used as the etching gas, the gas pressure was set to 5 mTorr, the ICP power was set to 400 W, and the bias power was set to 40 W. Overetching was performed by 100%.

Next, using the dry etching apparatus, the phase shift film including the protective layer and the phase layer was patterned. CF₄ and oxygen were used as the etching gas, the gas pressure was set to 5 mTorr, the ICP power was set to 400 W, and the bias power was set to 40 W. When the quartz substrate was dug by 3 nm on average, the dry etching was stopped.

Next, the resist pattern was peeled and cleaned by sulfuric acid-hydrogen peroxide mixture cleaning.

Next, using the dry etching apparatus, the light shielding film was removed. Chlorine, oxygen, and helium were used as the etching gas, the gas pressure was set to 10 mTorr, the ICP power was set to 500 W, and the bias power was set to 10 W. Overetching was performed by 200%. At this time, the phase shift film and the quartz substrate positioned below the light shielding film was not damaged.

This way, a phase shift mask according to Comparative Example 1 was obtained.

Next, the phase shift mask pattern was modified by EB modification. When a cross-sectional shape of the phase shift film pattern was observed, the edge was as illustrated in FIG. 5A, and the edge retraction amount was 20 nm. In addition, the level difference amount of the phase shift film pattern according to Comparative Example 1 was 0 nm.

Next, regarding the phase shift mask, a dosage at which the haze was formed by accelerated exposure was measured and was 135 kJ/cm².

It was verified from the above-described measurement result, in the phase shift mask according to Comparative Example 1, the dosage is 135 kJ/cm², and thus the formation of haze can be reduced. However, it was verified that, in the phase shift mask according to Comparative Example 1, the edge retraction amount is 20 nm as described above and is more than the edge retraction amount in each of the Examples, and thus the transfer performance is not sufficient. That is, it was verified that, in the phase shift mask according to Comparative Example 1, since the level difference amount y is 0 nm and the edge retraction amount x is 20 nm, the sum (x + y) of the edge retraction amount x and the level difference amount y is 20 nm, and the transfer performance is not sufficient.

### (Comparative Example 2)

Using a multi-source DC sputtering apparatus using two targets, a phase layer including silicon, molybdenum, oxygen, and nitrogen having a thickness of 66 nm was formed on a quartz substrate. Molybdenum and silicon were used as the targets, and argon, oxygen, and nitrogen were used as the sputtering gas.

Next, the voltage application to the molybdenum target was stopped, and by continuing the voltage application to the silicon target while introducing argon, oxygen, and nitrogen, a protective layer having a thickness of 8 nm was formed on the phase layer. That is, in Comparative Example 2, the graded layer was not formed.

When the obtained phase shift film was analyzed by ESCA, Si:Mo:O:N = 30:5:20:45 (at% ratio) in a region from the substrate side to a position of 66 nm. Next, Si:O:N = 40:40:20 (at% ratio) at a thickness of 8 nm. Next, when the phase shift film according to Comparative Example 2 was analyzed by ESCA, the composition ratio of the phase layer was Si:Mo:O:N = 30:5:20:45 (at% ratio). In addition, the composition ratio of the protective layer was Si:O:N = 40:40:20 (at% ratio).

In the formed phase shift film including the phase layer and the protective layer, the transmittance with respect to the exposure light was 7%, and the phase difference was 180 degrees.

Next, using the DC sputtering apparatus, a light shielding film including chromium, oxygen, and nitrogen having a thickness of 50 nm was formed on the protective layer. Chromium was used as the target, and argon, oxygen, and nitrogen were used as the sputtering gas. When the composition of the light shielding film was analyzed by ESCA, the composition was Cr:O:N = 55:35:10 (at% ratio).

Next, a negative chemically amplified electron beam resist having a film thickness of 200 nm was spin-coated on the light shielding film, and a pattern was drawn with an electron beam at a dosage of 35 µC/cm², was heated at 110°C for 10 minutes, and was developed by puddle development for 90 seconds to form a resist pattern.

Next, using the dry etching apparatus, the light shielding film was patterned. Chlorine, oxygen, and helium were used as the etching gas, the gas pressure was set to 5 mTorr, the ICP power was set to 400 W, and the bias power was set to 40 W. Overetching was performed by 100%.

Next, using the dry etching apparatus, the phase shift film including the protective layer and the phase layer was patterned. CF₄ and oxygen were used as the etching gas, the gas pressure was set to 5 mTorr, the ICP power was set to 400 W, and the bias power was set to 40 W. When the quartz substrate was dug by 3 nm on average, the dry etching was stopped.

Next, the resist pattern was peeled and cleaned by sulfuric acid-hydrogen peroxide mixture cleaning.

Next, using the dry etching apparatus, the light shielding film was removed. Chlorine, oxygen, and helium were used as the etching gas, the gas pressure was set to 10 mTorr, the ICP power was set to 500 W, and the bias power was set to 10 W. Overetching was performed by 200%. At this time, the phase shift film and the quartz substrate positioned below the light shielding film was not damaged.

This way, a phase shift mask according to Comparative Example 2 was obtained.

Next, the phase shift mask pattern was modified by EB modification. When a cross-sectional shape of the phase shift film pattern was observed, the edge was as illustrated in FIG. 5B, and the edge retraction amount was 10 nm. In addition, the level difference amount of the phase shift film pattern according to Comparative Example 2 was 10 nm.

Next, regarding the phase shift mask, a dosage at which the haze was formed by accelerated exposure was measured and was 100 kJ/cm².

It was verified from the above-described measurement result, in the phase shift mask according to Comparative Example 2, the dosage is 100 kJ/cm², and thus the formation of haze can be reduced. However, it was verified that, in the phase shift mask according to Comparative Example 2, the level difference amount is 10 nm as described above and is more than the level difference amount in each of the Examples, and thus the transfer performance is not sufficient. That is, it was verified that, in the phase shift mask according to Comparative Example 2, since the edge retraction amount x is 10 nm and the level difference amount y is 10 nm, the sum (x + y) of the edge retraction amount x and the level difference amount y is 20 nm, and the transfer performance is not sufficient.

The configurations of the phase shift mask blanks and the phase shift masks according to Examples 1 to 6 and Comparative Examples 1 and 2 are shown in Table 1 below.

**[Table 1]**

| | | | | | | | | | | |
|---|---|---|---|---|---|---|---|---|---|---|
| Light Shielding Film | | | CrON | CrON | CrON | CrON | CrON | CrON | CrON | CrON |
| Protective Layer | | | TaO | SiON | TaO | WO | TeO | SiON | TaSiON | SiON |
| Graded Layer | | | | | Graded Layer | Graded Layer | Graded Layer | Graded Layer | Graded Layer | Graded Layer |
| Phase Layer | | | MoSiON | MoSiON | MoSiON | MoSiON | MoSiON | MoSiON | MoSiON | MoSiON |
| Substrate | | | Qz | Qz | Qz | Qz | Qz | Qz | Qz | Qz |
| | | | Comp. Ex. 1 | Comp. Ex. 2 | Ex. 1 | Ex. 2 | Ex. 3 | Ex. 4 | Ex. 5 | Ex. 6 |
| Light Shielding Film | | Film Thickness (nm) | 50 | 50 | 50 | 50 | 50 | 50 | 50 | 50 |
| | | Composition | Cr:O:N=55:35:10 | Cr:O:N=55:35:10 | Cr:O:N=55:35:10 | Cr:O:N=55:35:10 | Cr:O:N=55:35:10 | Cr:O:N=55:35:10 | Cr:O:N=55:35:10 | Cr:O:N=55:35:10 |
| Protective Layer | (2) | Film Thickness (nm) | | | | | | | | 8 |
| | | Composition | | | | | | | | Si:O:N=40:40:20 |
| | (1) | Film Thickness (nm) | 8 | 8 | 2 | 2 | 2 | 8 | 8 | 0 |
| | | Composition | Ta:O=30:70 | Si:O:N=40:40:20 | Ta:O=30:70 | W:O=25:75 | Te:O=35:65 | Si:O:N=40:40:20 | Ta:Si:O:N=20:20:4 0:20 | Ta:Si:O:N=20:20:4 0:20 |
| Graded Layer | | Film Thickness (nm) | | | 8 | 8 | 8 | 5 | 5 | 5 |
| | | Composition | | | Si, Mo, N: Decrease Toward Protective Layer | Si, Mo, N: Decrease Toward Protective Layer | Si, Mo, N: Decrease Toward Protective Layer | Mo, N: Decrease Toward Protective Layer | Si, Mo, N: Decrease Toward Protective Layer | Si, Mo, N: Decrease Toward Protective Layer |
| | | | | | Ta, O: Increase Toward Protective Layer | W, O: Increase Toward Protective Layer | Te, O: Increase Toward Protective Layer | Si, O: Increase Toward Protective Layer | Ta, O: Increase Toward Protective Layer | Ta, O: Increase Toward Protective Layer |
| Phase Layer | | Film Thickness (nm) | 65 | 66 | 63 | 66 | 66 | 63 | 61 | 63 |
| | | Composition | Si:Mo:O:N = 30:5:20:45 | Si:Mo:O:N = 30:5:20:45 | Si:Mo:O:N = 30:5:20:45 | Si:Mo:O:N = 35:5:15:45 | Si:Mo:O:N = 40:8:7:45 | Si:Mo:O:N = 30:5:20:45 | Si:Mo:O:N = 30:5:20:45 | Si:Mo:O:N = 30:5:20:45 |
| Phase Difference and Transmittance of Phase Shift Film | | Transmittance (%) | 6 | 7 | 6 | 6 | 6 | 7 | 6 | 6 |
| | | Phase Difference (Degree) | 180 | 180 | 180 | 180 | 180 | 180 | 180 | 180 |
| Edge Retraction Amount (nm) | | | 20 | 10 | 14 | 15 | 14 | 5 | 12 | 7 |
| Level Difference (nm) | | | 0 | 10 | 0 | 0 | 0 | 5 | 5 | 7 |
| Dosage at which Haze is Formed by Accelerated Exposure (kJ/cm²) | | | 135 | 100 | 110 | 80 | 75 | 130 | 150 | 140 |

It can be seen from the above results that, in the phase shift mask according to each of the Examples, the amount of formation of haze can be reduced, and the edge retraction amount and the level difference amount of the pattern can be suppressed. In addition, since the edge retraction amount and the level difference amount of the pattern can be suppressed, excellent transfer performance can be given to the phase shift mask.

In addition, in the phase shift mask according to each of the Examples, the phase layer and the protective layer are formed with the graded layer interposed. Therefore, a clear interface is not formed between the phase layer and the protective layer, and thus excellent cleaning resistance can be given to the phase shift mask.

Hereinabove, the phase shift mask blank according to the present invention and the phase shift mask produced using the same have been described using the Examples. However, the Examples are merely exemplary for realizing the present invention, but the present invention is not limited thereto. In addition, it is obvious from the above description that modifications of the Examples are within the scope of the present invention and various other examples can be adopted within the scope of the present invention.

### Industrial Applicability

In the present invention, the composition, the film thickness, and the layer structure of the phase shift mask blank and the manufacturing steps and the conditions of the phase shift mask formed using the phase shift mask blank are selected in the appropriate ranges. Therefore, the phase shift mask where a fine pattern corresponding to the manufacturing of a logic device of 28 nm or less or a memory device of 30 nm or less is formed with high accuracy can be provided.

### Reference Signs List

10 phase shift mask blank
11 substrate that is transparent with respect to exposure wavelength (substrate)
12 phase shift film
13 phase layer (phase difference and transmittance adjustment layer)
14 graded layer (compositionally graded layer)
15 protective layer (protective layer against gas permeation)
16 light shielding film
17 resist pattern
18 phase shift film pattern
100 phase shift mask
d1 film thickness of phase layer
d2 film thickness of graded layer
d3 film thickness of protective layer

## Claims

1. A phase shift mask blank used for producing a phase shift mask to which exposure light having a wavelength of 200 nm or less is applied, the phase shift mask blank comprising:
a transparent substrate; and
a phase shift film formed on the transparent substrate,
wherein the phase shift film includes a phase difference and transmittance adjustment layer that is capable of adjusting a predetermined amount of each of a phase and a transmittance with respect to exposure light to be transmitted, a protective layer against gas permeation formed on the phase difference and transmittance adjustment layer and configured to prevent gas permeation to the phase difference and transmittance adjustment layer, and a compositionally graded layer that is positioned between the phase difference and transmittance adjustment layer and the protective layer against gas permeation and is a region where a ratio between a content of a component configuring the phase difference and transmittance adjustment layer and a content of a component configuring the protective layer against gas permeation continuously changes in a film thickness direction, and
in the compositionally graded layer, the content of the component configuring the phase difference and transmittance adjustment layer decreases from the substrate side toward the protective layer against gas permeation side, and the content of the component configuring the protective layer against gas permeation increases from the substrate side toward the protective layer against gas permeation side.

2. The phase shift mask blank according to claim 1,
wherein the phase difference and transmittance adjustment layer is positioned on the transparent substrate side, and
when a film thickness of the phase difference and transmittance adjustment layer is set to d1, a film thickness of the compositionally graded layer is set to d2, and a film thickness of the protective layer against gas permeation is set to d3, a total film thickness of d1 and d2 is more than d3 and d3 is 15 nm or less.

3. The phase shift mask blank according to claim 1 or 2,
wherein the phase shift film has resistance to oxygen-containing chlorine-based etching (Cl/O-based) and is etchable by fluorine-based etching (F-based).

4. The phase shift mask blank according to any one of claims 1 to 3,
wherein the phase difference and transmittance adjustment layer contains silicon and contains at least one selected from transition metal, nitrogen, oxygen, and carbon, and
the transition metal is at least one selected from molybdenum, titanium, vanadium, cobalt, nickel, zirconium, niobium, and hafnium.

5. The phase shift mask blank according to any one of claims 1 to 4,
wherein the protective layer against gas permeation contains at least one selected from tantalum metal, a tantalum compound, tungsten metal, a tungsten compound, tellurium metal, a tellurium compound, silicon metal, and a silicon compound.

6. The phase shift mask blank according to claim 5,
wherein the tantalum compound contains tantalum and at least one selected from oxygen, nitrogen, and carbon.

7. The phase shift mask blank according to claim 5,
wherein the tungsten compound contains tungsten and at least one selected from oxygen, nitrogen, and carbon.

8. The phase shift mask blank according to claim 5,
wherein the tellurium compound contains tellurium and at least one selected from oxygen, nitrogen, and carbon.

9. The phase shift mask blank according to claim 5,
wherein the silicon compound contains silicon and at least one selected from oxygen, nitrogen, and carbon.

10. A phase shift mask having a circuit pattern to which exposure light having a wavelength of 200 nm or less is applied, the phase shift mask comprising:
a transparent substrate; and
a phase shift film formed on the transparent substrate,
wherein the phase shift film includes a phase difference and transmittance adjustment layer that is capable of adjusting a predetermined amount of each of a phase and a transmittance with respect to exposure light to be transmitted, a protective layer against gas permeation formed on the phase difference and transmittance adjustment layer and configured to prevent gas permeation to the phase difference and transmittance adjustment layer, and a compositionally graded layer that is positioned between the phase difference and transmittance adjustment layer and the protective layer against gas permeation and is a region where a ratio between a content of a component configuring the phase difference and transmittance adjustment layer and a content of a component configuring the protective layer against gas permeation continuously changes in a film thickness direction, and
in the compositionally graded layer, the content of the component configuring the phase difference and transmittance adjustment layer decreases from the substrate side toward the protective layer against gas permeation side, and the content of the component configuring the protective layer against gas permeation increases from the substrate side toward the protective layer against gas permeation side.

11. The phase shift mask according to claim 10, wherein the phase difference and transmittance adjustment layer is positioned on the transparent substrate side, and
when a film thickness of the phase difference and transmittance adjustment layer is set to d1, a film thickness of the compositionally graded layer is set to d2, and a film thickness of the protective layer against gas permeation is set to d3, a total film thickness of d1 and d2 is more than d3 and d3 is 15 nm or less.

12. The phase shift mask according to claim 10 or 11,
wherein the phase shift film has resistance to oxygen-containing chlorine-based etching (Cl/O-based) and is etchable by fluorine-based etching (F-based).

13. The phase shift mask according to any one of claims 10 to 12,
wherein the phase difference and transmittance adjustment layer contains silicon and contains at least one selected from transition metal, nitrogen, oxygen, and carbon, and
the transition metal is at least one selected from molybdenum, titanium, vanadium, cobalt, nickel, zirconium, niobium, and hafnium.

14. The phase shift mask according to any one of claims 10 to 13,
wherein the protective layer against gas permeation contains at least one selected from tantalum metal, a tantalum compound, tungsten metal, a tungsten compound, tellurium metal, a tellurium compound, silicon metal, and a silicon compound.

15. The phase shift mask according to claim 14,
wherein the tantalum compound contains tantalum and at least one selected from oxygen, nitrogen, and carbon.

16. The phase shift mask according to claim 14,
wherein the tungsten compound contains tungsten and at least one selected from oxygen, nitrogen, and carbon.

17. The phase shift mask according to claim 14,
wherein the tellurium compound contains tellurium and at least one selected from oxygen, nitrogen, and carbon.

18. The phase shift mask according to claim 14,
wherein the silicon compound contains silicon and at least one selected from oxygen, nitrogen, and carbon.

19. A method for manufacturing a phase shift mask using the phase shift mask blank according to any one of claims 1 to 9, the method comprising:
forming a light shielding film on the phase shift film;
forming a resist pattern on the light shielding film;
forming a pattern on the light shielding film by oxygen-containing chlorine-based etching (Cl/O-based) after forming the resist pattern;
forming a pattern on the phase shift film by fluorine-based etching (F-based) after forming the pattern on the light shielding film;
removing the resist pattern after forming the pattern on the phase shift film; and
removing the light shielding film by oxygen-containing chlorine-based etching (Cl/O-based) from the phase shift film after removing the resist pattern.
